# EUROPÄISCHE PATENTSCHRIFT

(11) **EP 0 544 143 B1**
(45) Veröffentlichungstag und Bekanntmachung des Hinweises auf die Patenterteilung: **08.10.1997**
(21) Anmeldenummer: 92119216.7
(22) Anmeldetag: 10.11.1992
(51) Int. Cl.: H03K 17/30, H03K 19/0185

(54) **Integrierte Komparatorschaltung**
Integrated comparator circuit
Circuit comparateur intégré

(30) Priorität: 26.11.1991 DE 4138860
(43) Veröffentlichungstag der Anmeldung: 02.06.1993
(73) Patentinhaber: SIEMENS AKTIENGESELLSCHAFT, 80333 München (DE)
(72) Erfinder: Leipold, Ludwig, Dipl.-Ing., W-8000 München 40 (DE); Sander, Reinald, Dipl.-Phys., W-8000 München 40 (DE); Tihanyi, Jenö, Dr. Ing., W-8000 München 21 (DE)

(56) Entgegenhaltungen:
- DE-A- 3 906 482
- US-A- 4 658 156
- US-A- 4 709 172

## Beschreibung

Die Erfindung bezieht sich auf eine integrierte Komparatorschaltung mit einer aus zwei komplementären Transistoren bestehenden Inverterstufe, mit zwei weiteren komplementären Transistoren, die bezüglich ihrer Hauptstrompfade eine Reihenschaltung bilden, und mit einem ersten und zweiten Anschluß für die Betriebsspannung.

Eine solche Komparatorschaltung ist z. B. in dem Buch von Tietze-Schenk "Halbleiter-Schaltungstechnik", 7. Auflage, Seiten 140 ff. beschrieben worden. Diese Schaltung enthält bipolare Transistoren, Widerstände und Stromquellen. Damit unterschiedliche Komparatoren ein- und desselben Typs die gleichen Eigenschaften haben, müssen die Parameter der Transistoren des Eingangs-Differenzverstärkers gut reproduzierbar sein. Der Absolutwert des Schaltpunktes des Operationsverstärkers hängt außerdem von den Stromquellen ab. Auch deren Eigenschaften sind nicht immer einfach und reproduzierbar einzustellen. Die verwendeten integrierten Widerstände können ebenfalls in ihren Eigenschaften schwanken. Dazu kommt, daß sich Fabrikationsschwankungen auf die ihrem Aufbau nach unterschiedlichen Bestandteile sehr verschieden auswirken können.

Aus DE 39 06 482 Al ist eine integrierte Komparatorschaltung mit zwei komplementären MOSFET-Transistoren, die bezüglich ihrer Hauptstrompfade eine Reihenschaltung bilden, und mit einem ersten und zweiten Anschluß für die Betriebsspannung, bekannt. Die Reihenschaltung ist einerseits mit dem ersten Anschluß für die Betriebsspannung und andererseits mit einem dritten als Eingang für die zu vergleichende Spannung fungierenden Anschluß verbunden. Am Verbindungspunkt der MOSFET Reihenschaltung liegt das Ausgangssignal der Komparatorschaltung an.

Ziel der Erfindung ist es, eine integrierte Komparatorschaltung gemäß der eingangs erwähnten Gattung anzugeben, bei der keine Stromquellen und Widerstände nötig sind und bei der nur gleichartige Bauelemente verwendet werden.

Dieses Ziel wird durch die Merkmale des Anspruchs 1 erreicht.

Eine Weiterbildung der Erfindung ist Gegenstand des einzigen Unteranspruchs.

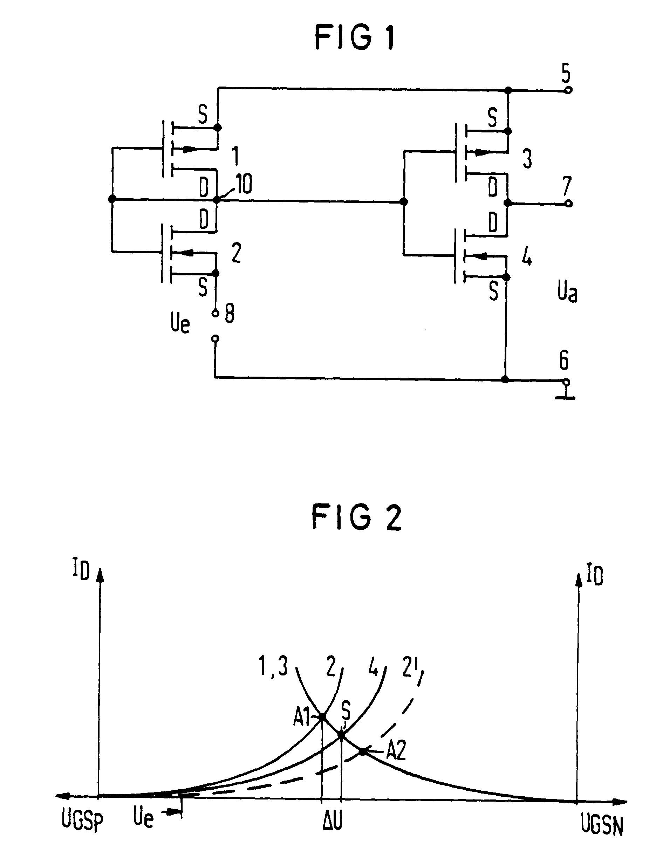

Die Erfindung wird anhand eines bevorzugten Ausführungsbeispiels näher erläutert, das in Figur 1 dargestellt ist. Die Wirkungsweise der Erfindung wird anhand des Diagramms nach Figur 2 erläutert.

Der integrierte Komparator nach Figur 1 enthält eine Inverterstufe mit einem p-Kanal-MOSFET 3 und einem n-Kanal-MOSFET 4. Beide MOSFET sind drainseitig miteinander verbunden. Der Sourceanschluß des MOSFET 3 ist mit einem Anschluß 5 verbunden, der Sourceanschluß des MOSFET 4 mit einem Anschluß 6. An die Anschlüsse 5, 6 wird die Versorgungsspannung V_{DD} angelegt. Die Drainanschlüsse beider Transistoren sind mit einem Ausgangsanschluß 7 verbunden. Die integrierte Komparatorschaltung enthält außerdem zwei in Reihe geschaltete komplementäre MOSFET 1 und 2. Der Sourceanschluß des p-Kanal-MOSFET 1 ist mit dem Anschluß 5 verbunden, der Sourceanschluß des n-Kanal-MOSFET 2 mit einem dritten Anschluß 8. Die Drainanschlüsse der MOSFET 1 und 2 sind elektrisch miteinander verbunden. Der Verbindungspunkt 10 ist mit den Gateanschlüssen der MOSFET 3 und 4 der Inverterstufe verbunden. Die Gateanschlüsse der MOSFET 1 und 2 der Reihenschaltung sind mit ihren Drainanschlüssen verbunden, so daß beide MOSFET als MOS-Dioden arbeiten. Die Anschlüsse 8 und 6 bilden den Eingang für die zu vergleichende Spannung Uₑ.

Ist die zu vergleichende Spannung Null, so liegt der Sourceanschluß des MOSFET 2 über den die Spannung Uₑ liefernden Generator auf Null Volt. Die MOSFET 1 und 2 bilden einen Spannungsteiler, der am Verbindungspunkt 10 ein vorbestimmtes Potential einstellt. Das Spannungsteilerverhältnis ist hierbei so gewählt, daß im Zustand Uₑ = 0V der MOSFET 3 so weit leitend gesteuert ist, daß er einen kleineren Widerstand bildet als der MOSFET 4. Damit liegt die Spannung an den Anschlüssen 6, 7 auf H-Pegel. Dieser Zustand ist in Figur 2 durch den Schnittpunkt A1 der Übertragungs-Kennlinien (U_{GS}/I_{D}) der MOSFET 1 und 2 gegeben. Die Übertragungs-Kennlinien der MOSFET 1 und 2 sind in Figur 2 ebenfalls mit 1 bzw. 2 bezeichnet. Der Schaltpunkt S des Inverters ist durch den Schnittpunkt der Übertragungs-Kennlinien der MOSFET 3 und 4 gegeben. Deren Übertragungs-Kennlinien sind in Figur 2 mit 3 bzw. 4 bezeichnet.

Wird eine positive Spannung Uₑ an die Anschlüsse 8, 6 angelegt, so verschiebt sich das Potential am Verbindungspunkt 10 in Richtung auf V_{DD}. Damit wird der MOSFET 4 stärker leitend, die Leitfähigkeit des MOSFET 3 nimmt ab. Die Ausgangsspannung Uₐ sinkt damit auf den Pegel "L". Der negative Spannungshub am Ausgang signalisiert somit, daß am Eingang 6, 8 eine Spannung Uₑ anliegt. Die Spannung Uₐ kann anschließend einem Schmitt-Trigger zugeführt werden, dessen Ausgangssignalpegel so gewählt sind, daß sie logisch "0" oder logisch "1" entsprechen.

Um eine definierte Ansprechschwelle der Komparatorschaltung für Uₑ > 0 Volt einzustellen, werden die Übertragungs-Kennlinien der MOSFET 2 und 4 unterschiedlich gewählt. Die Übertragungs-Kennlinien der MOSFET 1 und 3 können, müssen jedoch nicht gleich sein. Die Darstellung nach Figur 2 geht davon aus, daß die Übertragungs Kennlinien der MOSFET 1 und 3 gleich sind, daß der MOSFET 2 jedoch eine Übertragungs-Kennlinie besitzt, die steiler verläuft als die des MOSFET 4. Damit wird eine Ansprechschwelle Δ U erreicht, die größer als Null Volt ist. Durch Anlegen der Spannung Uₑ verschiebt sich die Übertragungs-Kennlinie dann in einen Bereich, der eine eindeutige Unterscheidung der beiden Zustände am Ausgang 6, 7 des Inverters zuläßt. Die verschobene Übertragungs-Kennlinie des MOSFET 2 ist in Figur 2 gestrichelt gezeichnet und mit 2' gekennzeichnet. Als Arbeitspunkt stellt sich nun A2 ein.

Als Spezialfall wäre es auch denkbar, daß die Übertragungs-Kennlinien der MOSFET 2 und 4 gleich sind. Damit würde die Komparatorschaltung jedoch schon bei Uₑ = 0 Volt ansprechen.

In Abwandlung des gezeigten Ausführungsbeispiels ist es auch möglich, die Spannung Uₑ zwischen den Sourceanschluß des MOSFET 1 und dem Anschluß 5 anzulegen. In diesem Fall empfiehlt es sich dann, die Übertragungs-Kennlinie des MOSFET 1 steiler als die des MOSFET 3 zu machen. Die Übertragungs-Kennlinien der MOSFET 2 und 4 können, müssen jedoch nicht gleich sein.

Für negative Betriebsspannung V_{DD} sind jeweils die inversen Kanaltypen zu verwenden.

Die unterschiedliche Steilheit der Übertragungs-Kennlinien läßt sich bei sonst identischen Parametern z. B. durch unterschiedliche Kanalweiten der MOSFET einstellen. Im Ausführungsbeispiel nach Figur 1 wäre somit die Kanalweite des MOSFET 2 größer als die des MOSFET 4 einzustellen. Die Kanalweiten der MOSFET 1 und 3 können gleich sein. Dadurch, daß sämtliche MOSFET der integrierten Komparatorschaltung den gleichen Herstellungsbedingungen unterworfen sind, ändern Schwankungen im Herstellungsprozeß die Eigenschaften aller vier MOSFET in der gleichen Weise. Dadurch wird eine gute Einhaltung der Parameter der integrierten Komparatoranordnung erreicht mit der Wirkung, daß der Schaltpunkt von Invertern ein- und desselben Typs von Herstellungsschwankungen im wesentlichen unabhängig ist.

## Patentansprüche

1. Integrierte Komparatorschaltung mit einer aus zwei komplementären Transistoren (3, 4) bestehenden Inverterstufe, mit zwei weiteren komplementären Transistoren (1, 2), die bezüglich ihrer Hauptstrompfade eine Reihenschaltung bilden und mit einem ersten (5) und zweiten (6) Anschluß für die Betriebsspannung, mit den Folgenden Merkmalen :
a) die Transistoren sind MOSFET (1,2,3,4),
b) die Gateanschlüsse der MOSFET (3,4) der Inverterstufe sind mit dem Verbindungspunkt (10) der MOSFET (1,2) der Reihenschaltung verbunden,
c) die Reihenschaltung und die Inverterstufe sind einerseits mit dem ersten Anschluß (5) und andererseits mit einem dritten (8) bzw. mit dem zweiten Anschluß (6) verbunden,
d) der zweite und der dritte Anschluß sind der Eingang für eine zu vergleichende Spannung (Uₑ),
e) die jeweils mit dem ersten Anschluß (5) verbundenen MOSFET (1,3) und die mit dem zweiten (6) bzw. dritten Anschluß (8) verbundenen MOSFET (2,4) sind vom gleichen Kanaltyp,
f) die Gate-Anschlüsse und Drain-Anschlüsse der MOSFET (1, 2) der Reihenschaltung sind miteinander verbunden.

2. Integrierte Komparatorschaltung nach Anspruch 1,
**dadurch gekennzeichnet**, daß
die Übertragungs-Kennlinien (U_{GS}/I_{D}) der mit dem ersten Anschluß (5) verbundene MOSFET (1,3) gleich sind und daß die Übertragungs-Kennlinien des mit dem dritten Anschluß (8) verbundenen MOSFET (2) steiler ist als die Übertragungs-Kennlinie des mit dem zweiten Anschluß (6) verbundenen MOSFET (4).

## Claims

1. Integrated comparator circuit having an inverter stage comprising two complementary transistors (3, 4), having two further complementary transistors (1, 2), which form a series connection with respect to their main current paths, and having a first (5) and a second (6) terminal for the operating voltage, having the following features:
a) the transistors are MOSFETs (1, 2, 3, 4),
b) the gate terminals of the MOSFETs (3, 4) of the inverter stage are connected to the tie point (10) of the MOSFETs (1, 2) of the series connection,
c) the series connection and the inverter stage are connected on the one hand to the first terminal (5), and on the other hand to a third (8) or to the second terminal (6),
d) the second and the third terminals are the input for a voltage (Uₑ) to be compared,
e) the MOSFETs (1, 3) connected in each case to the first terminal (5), and the MOSFETs (2, 4) connected to the second (6) or third terminal (8) are of the same channel type, and
f) the gate terminals and drain terminals of the MOSFETs (1, 2) of the series connection are connected to one another.

2. Integrated comparator circuit according to Claim 1, characterized in that the transfer characteristics (U_{GS}/I_{D}) of the MOSFETs (1, 3) connected to the first terminal (5) are the same, and in that the transfer characteristic of the MOSFET (2) connected to the third terminal (8) is steeper than the transfer characteristic of the MOSFET (4) connected to the second terminal (6).

## Revendications

1. Circuit comparateur intégré, comprenant un circuit inverseur composé de deux transistors (3, 4) complémentaires, comprenant deux autres transistors (1, 2) complémentaires dont les voies de courant principal sont montées en série, et comprenant une première (5) et une deuxième borne (6) pour la tension de service, le circuit ayant les caractéristiques suivantes :
a) les transistors sont des MOSFET (1, 2, 3, 4),
b) les bornes de grille des MOSFET (3, 4) du circuit inverseur sont reliées au point de jonction (10) des MOSFET (1, 2) du montage en série,
c) le montage en série et le circuit inverseur sont reliés d'une part à la première borne (5) et d'autre part respectivement à une troisième (8) et à la deuxième borne (6),
d) la deuxième et la troisième borne constituent l'entrée pour une tension à comparer (Uₑ),
e) les MOSFET (1, 3) reliés chacun à la première borne (5) et les MOSFET (2, 4) reliés respectivement à la deuxième (6) et à la troisième borne (8) ont des canaux du même type,
f) les bornes de grille et les bornes de drain des MOSFET (1, 2) du montage en série sont reliées entre elles.

2. Circuit comparateur intégré selon la revendication 1, caractérisé en ce que les caractéristiques de transfert (U_{GS}/I_{D}) des MOSFET (1, 3) reliés à la première borne (5) sont identiques et en ce que les caractéristiques de transfert du MOSFET (2) relié à la troisième borne (8) ont une pente plus forte que les caractéristiques de transfert du MOSFET (4) relié à la deuxième borne (6).
